# EUROPÄISCHE PATENTSCHRIFT

(11) **EP 2 082 483 B1**
(45) Veröffentlichungstag und Bekanntmachung des Hinweises auf die Patenterteilung: **06.04.2011**
(21) Anmeldenummer: 07818646.7
(22) Anmeldetag: 02.10.2007
(51) Int. Cl.: H03K 17/955, E05F 15/00, G01V 3/08, G01D 5/24, G01D 18/00

(54) **EINKLEMMSENSOR**
ANTI-PINCH SENSOR
CAPTEUR ANTI-PINCEMENT

(30) Priorität: 13.10.2006 DE 202006015740 U
(43) Veröffentlichungstag der Anmeldung: 29.07.2009
(73) Patentinhaber: Brose Fahrzeugteile GmbH & Co. Kommanditgesellschaft Coburg, 96450 Coburg (DE)
(72) Erfinder: WÜRSTLEIN, Holger, 97475 Zeil am Main (DE); WEINGÄRTNER, Thomas, 96117 Memmelsdorf (DE); MÜLLER, Wolf-Christian, 69123 Heidelberg (DE)
(74) Vertreter: FDST Patentanwälte
(86) Internationale Anmeldenummer: PCT/EP2007/008566
(87) Internationale Veröffentlichungsnummer: WO 2008/046514

(56) Entgegenhaltungen:
- EP-A- 1 450 489
- WO-A-97/29391
- DE-A1- 4 006 119
- US-B1- 6 310 611

## Beschreibung

Die Erfindung betrifft einen Einklemmsensor, insbesondere zum Erkennen eines Hindernisses im Weg eines Stellelements eines Kraftfahrzeugs.

Bekannte Einklemmsensoren nutzen zum Erkennen eines Hindernisses beispielsweise das kapazitive Messprinzip. Dabei wird zwischen einer Messelektrode und einer geeigneten Gegenelektrode ein elektrisches Feld aufgebaut. Tritt in dieses elektrische Feld ein Dielektrikum ein, so verändert sich die Kapazität des von der Messelektrode und der Gegenelektrode gebildeten Kondensators. Auf diese Weise kann theoretisch ein Hindernis im Weg eines Stellelements eines Kraftfahrzeugs detektiert werden, sofern sich dessen relative Dielektrizitätszahl εᵣ von der relativen Dielektrizitätszahl von Luft unterscheidet. Das Hindernis im Weg eines Stellelements wird ohne einen physischen Kontakt mit dem Einklemmsensor erkannt. Wird eine Kapazitätsänderung detektiert, so können rechtzeitig Gegenmaßnahmen, wie beispielsweise ein Stoppen oder ein Reversieren des Antriebs eingeleitet werden, bevor es zu einem tatsächlichen Einklemmen des Hindernisses kommt.

Bei den Stellelementen eines Kraftfahrzeuges kann es sich beispielsweise um ein elektrisch betätigbares Fenster, eine elektrisch betätigbare Schiebetür oder eine elektrisch betätigbare Heckklappe handeln. Auch kann ein auf dein kapazitiven Messprinzip beruhender Einklemmsensor zur Detektion von Hindernissen im Falle eines elektrisch betätigbaren Sitzes eingesetzt werden.

Berührungslos arbeitende, auf dem kapazitiven Messprinzip beruhende Einklemmsensoren sind beispielsweise aus der EP 1 455 044 A2 und der EP 1 154 110 A2 bekannt. Diese bekannten Einklemmsensoren erzeugen mittels einer Messelektrode und einer geeigneten Gegenelektrode ein äußeres elektrisches Feld, so dass ein in dieses äußere elektrische Feld eindringendes Dielektrikum als eine Kapazitätsänderung zwischen Messelektrode und Gegenelektrode detektiert werden kann. Um eine hohe Sicherheit bei der Detektion eines Einklemmfalles gewährleisten zu können, ist zusätzlich bei beiden vorbekannten Einklemmsensoren der Abstand zwischen Messelektrode und Gegenelektrode flexibel gestaltet, wodurch auch ein physischer Kontakt eines Hindernisses mit dem Einklemmsensor als eine Kapazitätsänderung detektierbar wird.

Auch aus der EP 1 371803 A1 ist ein auf dem kapazitiven Messprinzip beruhender Einklemmsensor bekannt. Hierbei wird zur Erzeugung eines elektrischen Feldes im Öffnungsbereich des Stellelements eine Sensorelektrode eingesetzt, die über eine geschirmte Zuleitung mit einer Auswerteeinheit verbunden ist. Das elektrische Feld wird hierbei gegenüber der Karosserie eines Kraftfahrzeugs als Gegenelektrode erzeugt. Ein weiterer Näherungssensor ist aus der DE 4006 119 A1 bekannt.

Nachteiligerweise besteht bei den bekannten, auf dem kapazitiven Messprinzip beruhenden Einklemmsensoren die Gefahr einer Fehldetektion eines Einklemmfalles, wenn sich Schmutz oder Wasser auf dem Sensor befindet. Denn auch Schmutz oder Wasser führt zu einer geänderten Kapazität, so dass irrtümlich auf einen vorliegenden Einklemmfall geschlossen werden würde.

Der Erfindung liegt die Aufgabe zugrunde, einen nach dem kapazitiven Messprinzip arbeitenden Einklemmsensor der eingangs genannten Art anzugeben, bei welchem die Gefahr einer Fehldetektion im Falle einer Ablagerung von Schmutz oder Wasser möglichst gering ist.

Diese Aufgabe wird erfindungsgemäß durch einen Einklemmsensor der eingangs genannten Art gelöst, der einen Sensorkörper mit einer im Sensorkörper angeordneten, auf ein Messpotential legbaren Messelektrode und mit einer der Messelektroden im Sensorkörper benachbart angeordneten elektrisch getrennten, auf ein Kalibrierpotential legbaren Kalibrierelektrode sowie eine Steuereinheit umfasst, wobei die Steuereinheit dafür eingerichtet ist, die Messelektrode und die Kalibrierelektrode derart anzusteuern, dass sich das Messpotential und das Kalibrierpotential in einer Messphase gleichen und in einer Kalibrierphase voneinander unterscheiden.

Die Erfindung basiert auf der Überlegung, eine grundsätzlich zur Erzeugung eines äußeren Feldes vorgesehene Elektrode in elektrisch getrennte Elektroden aufzuteilen, wodurch eine Erfassung und eine Kompensation einer durch Schmutz oder Wasser gebildeten Ablagerung auf der Oberfläche des Sensorkörpers ermöglicht wird. Die entsprechend der Erfindung elektrisch getrennten Elektroden, nämlich eine Messelektrode und eine Kalibrierelektrode, sind sowohl auf gleiches als auch auf verschiedenes Potential legbar.

In der Messphase wird auf beide Elektroden das gleiche Potential gelegt, so dass sich insgesamt ein elektrisches Feld, im weiteren Messfeld genannt, gegenüber einer Gegenelektrode zur Erfassung eines Hindernisses im Weg des Stellelements ausbildet. Zwischen den Elektroden bildet sich dabei kein elektrisches Feld aus, so dass beide Elektroden wie eine einzige Elektrode wirken, deren Fläche sich aus den Flächen der Mess- und der Kalibrierelektrode zusammensetzt. Die Gegenelektrode kann hierbei Teil des Einklemmsensors selbst sein, oder sie kann aber auch durch die geerdete Karosserie eines Kraftfahrzeugs gebildet sein. Ein in das Messfeld eindringendes Dielektrikum kann insbesondere über eine Änderung der Kapazität des aus Mess- sowie Kalibrierelektrode und der Gegenelektrode gebildeten Kondensators detektiert werden.

Schmutz oder Wasser, die als Ablagerungen oder Benetzung die Oberfläche des Sensorkörpers beaufschlagen, sind durch eine Dielektrizitätszahl gekennzeichnet, die sich von der der Luft unterscheidet. Somit bewirkt auch eine derartige Ablagerung an der Sensoroberfläche eine Änderung des in der Messphase erzeugten elektrischen Feldes und somit der Kapazität des Kondensators aus Mess- sowie Kalibrierelektrode und der Gegenelektrode. Diese Kapazitätsänderung kann irrtümlicherweise als durch ein Hindernis hervorgerufen interpretiert werden und als Fehlfunktion zur Einleitung eines Reversiervorgangs des Stellelements führen.

Die Auftrennung in eine Mess- und eine Kalibrierelektrode ermöglicht es jedoch, eine Nahfeldänderung durch eine Ablagerung auf der Sensoroberfläche von einer Fernfeldänderung durch ein Hindernis zu unterscheiden. Hierzu werden in der Kalibrierphase die Messelektrode und die Kalibrierelektrode auf unterschiedliche Potentiale gelegt. Dies führt dazu, dass sich ein elektrisches Feld, im weiteren auch als Kalibrierfeld bezeichnet, zwischen der Messelektrode und der Kalibrierelektrode bildet. Neben einem direkten Feld entsteht hierbei auch ein Streufeld mit geringer Ausdehnung, dessen Feldlinien die Oberfläche des Sensorkörpers durchdringen. Das Kalibrierfeld weist insgesamt eine geringe räumliche Ausdehnung aufgrund der benachbarten Anordnung der Elektroden auf. Somit wird die Größe des Kalibrierfeldes insbesondere von einer Ablagerung auf der Sensoroberfläche beeinflusst. Durch das Erzeugen des Kalibrierfeldes ist es somit möglich, die durch eine Ablagerung auf der Sensoroberfläche hervorgerufene Nahfeldbeeinflussung direkt zu ermitteln und zu einer Kompensation der Messung mittels des Messfeldes heranzuziehen, welches aufgrund seiner größeren räumlichen Ausdehnung (Entfernung zur Gegenelektrode) sowohl im Nahfeld durch eine Ablagerung als auch im Fernfeld durch ein Hindernis beeinflusst wird.

Die unterschiedlichen Reichweiten von Mess- und Kalibrierfeld können dabei durch die Geometrie und/oder Dimensionierung der Kondensatoranordnungen, die in der Mess- und in der Kalibrierphase entstehen, beeinflusst werden. So kann beispielsweise die Kalibrierelektrode zur Erzielung eines möglichst kurzreichweitigen Kalibrierfeldes derart ausgestaltet sein, dass die Feldlinien einen möglichst direkten Verlauf zwischen Kalibrierelektrode und Messelektrode aufweisen. Auch kann beispielsweise die Fläche der Kalibrierelektrode zur Messelektrode klein ausgebildet sein.

Die Einstellung der Messphase und der Kalibrierphase bzw. der Wechsel zwischen beiden Phasen kann sowohl automatisch, insbesondere in vordefinierten Zeitabständen, als auch bei Bedarf erfolgen. Im ersten Fall kann beispielsweise durch eine geeignete Ansteuerung periodisch zwischen den Phasen umgeschaltet werden. Im zweiten Fall kann insbesondere bei einer fehlerhaften Interpretation einer Ablagerung oder Benetzung der Sensoroberfläche als Hindernis eine benutzerbedingte Kalibrierung des Einklemmsensors erfolgen.

Ein Einklemmfall wird üblicherweise ausgehend von der Erfassung einer Feldänderung des Messfeldes, insbesondere mittels einer Messung der Kapazität, detektiert, wenn die Änderung gegenüber dem Erwartungswert eine vorgegebene Auslöseschwelle überschreitet. Damit eine Änderung aufgrund Verschmutzung oder Benetzung der Sensoroberfläche nicht zu einer unerwünschten Fehlinterpretation als ein Einklemmfall und somit zu einem störenden Stoppen oder zu einem Reversieren des Stellelements führt, ohne dass ein Hindernis im Stellweg wäre, ist es erforderlich, die Auslöseschwelle in bestimmten Zeitabständen nachzuführen oder zu aktualisieren. Daher ist gemäß einer bevorzugten Ausgestaltung die Steuereinheit dafür eingerichtet, während der Kalibrierphase eine Kalibrierkapazität zu erfassen und zu speichern und diese Kalibrierkapazität bei der Auswertung einer in der Messphase erfassten Messkapazität zu berücksichtigen. Eine Nahfeldänderung durch eine Schmutz- oder Wasserablagerung wird also während der Kalibrierphase über die Kapazität zwischen der Kalibrier- und der Messelektrode gemessen. Da auch das Messfeld durch die Ablagerung auf der Sensoroberfläche beeinflusst ist, kann die Änderung der Kalibrierkapazität zur Kalibrierung der Messkapazität herangezogen werden. Der Einfluss der Kalibrierkapazität auf die Messkapazität kann hierzu aus theoretischen Betrachtungen, in die beispielsweise geometrische Aspekte einfließen, hergeleitet oder experimentell bestimmt werden. Bei einer Änderung der Kalibrierkapazität im Vergleich zu ihrem letzten gespeicherten Wert wird die Auslöseschwelle selbst oder der Erwartungswert, gegenüber dem die Auslöseschwelle definiert ist, neu festgelegt, um eine Fehlinterpretation der erfassten Messkapazität zu vermeiden.

Die Nachführung der Auslöseschwelle kann grundsätzlich auf verschiedene Weise erfolgen. Zum einen kann eine softwarebedingte Nachführung der Auslöseschwelle erfolgen, indem die Steuereinheit den Erwartungswert der Messkapazität entsprechend der gemessenen Kalibrierkapazität anpasst, wodurch sich auch der Bereich der Auslöseschwelle, der dem Erwartungswert der Messkapazität folgt, verschiebt, oder indem nach einer Änderung der Kalibrierkapazität direkt ein neuer aktueller Wert oder ein neuer Verlauf für die Auslöseschwelle bestimmt wird, der bei der Auswertung der Messkapazität verwendet wird. Alternativ kann die Nachführung aber auch auf elektronischem Wege mittels geeigneter elektronischer Schaltmittel erfolgen. In diesem Fall wird die elektronische Verarbeitung durch Hardwarebeeinflussung, beispielsweise mittels steuerbarer Elemente, so beeinflusst, dass der Steuereinheit, die einen Einklemmfall erkennt, unabhängig von der geänderten Messkapazität stets das gleiche Signal für einen Normalbetrieb und für einen Einklemmfall zugeleitet wird.

Wird die Messkapazität beispielsweise mittels einer Brückenschaltung erfasst, so bietet es sich an, einen zweiten Brückenzweig gleicher Ausgestaltung als Referenz parallel zu schalten und als Messsignal die Differenz der jeweils zwischen Widerstand und Kapazität abgegriffenen Spannungen, bzw. deren Amplituden oder gegenseitige Phasenlage, zu erfassen. Auf diese Weise lässt sich im Regelfall ein Standardsignal gleich Null und im Einklemmfall ein Einklemmsignal ungleich Null erzeugen, so dass sich ein Einklemmfall vom Regelfall leicht auf elektronischem Weg, beispielsweise mittels eines Komparators, unterscheiden lässt. Dies ermöglicht es weiter, als Detektionssignal der Steuereinheit ein digitales Signal zuzuführen. Zur Ausregelung der beiden Brückenzweige bietet es sich an, eine steuerbare Kapazität, insbesondere eine steuerbare Kapazitätsdiode, einzusetzen. Durch Regelung der Kapazitätsdiode mittels der Steuereinheit ist es möglich, die Auslöseschwelle einer durch Ablagerungen geänderten Messkapazität nachzuführen.

Nach einer bevorzugten Ausgestaltung ist die Steuereinheit dafür eingerichtet, die Messelektrode und die Kalibrierelektrode jeweils mit einer Wechselspannung anzusteuern, wobei sich die Wechselspannungen in ihren Phasen zueinander oder in ihren Frequenzen unterscheiden. In beiden Fällen wird erreicht, dass die gemessene Gesamtkapazität oder Teilkapazitäten Anteile sowohl der Messphase als auch der Kalibrierphase beinhaltet. Bei Verwendung zweier Wechselspannungen verschiedener Phase oder Frequenz zur Ansteuerung der Elektroden variiert nämlich die Potentialdifferenz sowohl zwischen den beiden Elektroden als auch gegenüber der Gegenelektrode periodisch mit der Zeit. Aus dem zeitlichen Verlauf der gemessenen Kapazität oder Kapazitäten kann somit sowohl auf die Messkapazität als auch auf die Kalibrierkapazität rückgeschlossen werden. Somit kann mit einfachen Mitteln ein Wechsel zwischen Mess- und Kalibrierphase erreicht werden, so dass eine kostengünstige und einfache Kompensation von Schmutz- oder Wasserablagerungen auf der Sensoroberfläche erreicht wird.

Für eine sichere Detektion einer Ablagerung oder Benetzung ist es vorteilhaft, das Kalibrierfeld zu erfassen, wenn die Potentialdifferenz zwischen den Elektroden am größten ist. Daher ist die Steuereinheit vorzugsweise dafür eingerichtet, als Messphase einen Bereich heranzuziehen, in dem die Amplituden der Wechselspannungen im Wesentlichen gleich sind und als Kalibrierphase einen Bereich heranzuziehen, in dem die Amplituden der Wechselspannungen möglichst unterschiedlich sind.

Alternativ zum Beaufschlagen der Elektroden mit Wechselspannungen unterschiedlicher Phase oder Frequenz wird die Messelektrode in der Kalibrierphase vorzugsweise mit einem Grundpotential, insbesondere mit dem Erdpotential, verbunden. Durch das Verbinden der Messelektrode mit dem Erdpotential wird die größte mögliche Potentialdifferenz zwischen der Mess- und der Kalibrierelektrode eingestellt, so dass sich ein besonders intensives Kalibrierfeld ausbildet.

Bevorzugt ist die Steuereinheit als ein Mikrokontroller ausgebildet, der insbesondere bei der softwarebedienten Nachführung der Auslöseschwelle eingesetzt wird.

In einer zweckdienlichen Ausgestaltung der Erfindung sind die Elektroden jeweils flächig ausgebildet und die Fläche der Messelektrode ist größer als die Fläche der Kalibrierelektrode. Über die Größe der Flächen wird hierbei die Mess- sowie die Kalibrierkapazität in bekannter Weise ermittelt bzw. angepasst. Insbesondere kann auch die Reichweite des sich in den Öffnungsbereich hinein erstreckenden Messfeldes durch eine Vergrößerung der Fläche der Messelektrode erhöht werden. Durch eine Kombination aus Anordnung und Dimensionierung, wobei insbesondere auch der spätere Einsatz des Einklemmsensors und damit die Geometrie einer Kraftfahrzeugkarosserie zu beachten ist, kann eine für die Auswertung der Kapazitätsänderung gewünschte Kapazitätsanpassung im Mess- und im Kalibrierfeld erzielt werden.

In einer anderen zweckdienlichen Ausgestaltung sind die Messelektrode und die Kalibrierelektrode jeweils kammförmig ausgestaltet, wobei die Kammstrukturen von Kalibrierelektrode und Messelektrode ineinandergreifen. Dies ermöglicht die Erfassung einer inhomogenen Wasser oder Schmutzverteilung auf der Sensoroberfläche. Eine Schmutz- oder Wasserablagerung in der Nähe der ineinandergreifenden Zähne der Kammstrukturen beeinflusst die Kapazität zwischen Mess- und Kalibrierelektrode anders als eine hiervon entfernte Ablagerung. Somit lässt sich hierdurch eine Ortsauflösung quer zur Sensorlängsrichtung erzielen.

Um zu vermeiden, dass sich die Feldlinien aus der Kalibrierelektrode in der Kalibrierphase direkt zur Gegenelektrode ausrichten, sind vorteilhafterweise zwei Messelektroden, insbesondere zwei baugleiche Messelektroden vorgesehen, die in den Randbereichen des Sensorkörpers angeordnet sind, so dass die Kalibrierelektrode zwischen den beiden positioniert ist. Dank dieser Anordnung erstrecken sich die Feldlinien des Kalibrierfelds von der Kalibrierelektrode in Richtung der randseitig angeordneten Messelektroden und das Kalibrierfeld bildet sich zumindest teilweise über dem Sensorkörper aus. Alternativ können aber auch zwei Kalibrierelektroden am Rand des Sensors vorgesehen sein, die an die mittig positionierte Messelektrode angrenzen. Im Falle der Ausgestaltung als kammförmige Strukturen ist die jeweils mittige Elektrode als ein Doppelkamm ausgestaltet, der beidseitig mit den äußeren Kammstrukturen der weiteren Elektroden kämmt.

Um ein elektrisches Nutzfeld, mit hoher Reichweite zu erzielen, ist in einer zweckdienlichen Ausgestaltung im Sensorkörper eine separate Abschirmelektrode vorgesehen, die zur Ausrichtung des Messfeldes in der Messphase in einen Gefährdungsbereich ausgebildet ist, indem sie auf das gleiche Potential wie die Mess- und die Kalibrierelektroden gelegt wird. Wird beispielsweise die Karosserie eines Kraftfahrzeugs als Gegenelektrode eingesetzt, auf welche der Einklemmsensor aufgelegt wird, so ist die separate Abschirmelektrode zwischen der Karosserie und den Elektroden im Sensorkörper anzuordnen. Durch eine Potenzialangleichung zwischen dem Potenzial, auf welchem sich sowohl die Mess- als auch die Kalibrierelektrode in der Messphase befinden, und dem Potenzial, auf welchem sich die Abschirmelektrode befindet, wird erreicht, dass sich zwischen den Elektroden und der Gegenelektrode kein direktes elektrisches Feld und somit keine direkte Kapazität ausbildet. Vielmehr werden die Feldlinien des elektrischen Feldes zwischen den Elektroden und der Gegenelektrode in den zu erfassenden Gefährdungsbereich hinein gelenkt.

Im Falle einer Messelektrode und einer Kalibrierelektrode erstreckt sich eine Abschirmelektrode vorteilhafterweise flächig komplett unter beide Elektroden. In der Messphase befinden sich dann alle Elektroden auf demselben Potential, wodurch sich das Messfeld weit in den Gefährdungsbereich hinein erstreckt. In der Kalibrierphase wird die Messelektrode mit Masse bzw. dem Grundpotential beaufschlagt. Die Abschirmelektrode befindet sich dabei auf demselben Potential wie die Kalibrierelektrode. Hierdurch wird erzielt, dass sich das Kalibrierfeld in den Nahbereich erstreckt.

Vorteilhafterweise ist ergänzend zur Abschirmelektrode eine Zusatzelektrode vorgesehen, die zwischen der Messelektrode und der Kalibrierelektrode angeordnet ist und auf das gleiche Potential legbar ist wie die Kalibrierelektrode. Die Zusatzelektrode verhindert die Bildung eines direkten elektrischen Feldes zwischen der Mess- und der Kalibrierelektrode und vergrößert den Anteil des Streufeldes, so dass ein großer Teil der Feldlinien des Kalibrierfeldes in der Kalibrierphase günstigerweise durch den Sensor körper nach außen verlaufen und somit die Erfassung von Ablagerungen auf der Oberfläche des Sensorkörpers, d.h. in einem Nahbereich ermöglichen.

In einer einfachen Ausgestaltung ist die Abschirmelektrode als ein zusammenhängender flächiger Leiter ausgestaltet. In einer vorteilhaften Ausgestaltung ist jedoch die Abschirmelektrode in einzelne, jeweils den Elektroden gegenüber angeordnete und getrennte Einzelabschirmelektroden unterteilt. Dies erlaubt eine bessere Potenzialabgleichung gegenüber den abzuschirmenden einzelnen Elektroden. Insbesondere ist es hierbei möglich, zwei Arten von Einzelabschirmelektroden vorzusehen, nämlich solche, die zur Abschirmung der Messelektrode dienen und sich stets auf dem gleichen Potential befinden wie die Messelektrode, und solche, die sich auf gleichem Potential befinden wie die Kalibrierelektrode. Somit wird in der Kalibrierphase verhindert, dass sich ein direktes elektrisches Feld zwischen der Mess- bzw. Kalibrierelektrode und der Gegenelektrode bildet.

In einer zweckmäßigen Ausgestaltung ist der Sensorkörper aus einem flexiblen Trägermaterial gebildet. Dies erlaubt es, den Einklemmsensor leicht entlang der Kontur einer Schließkante eines Kraftfahrzeugs zu führen. Insbesondere kann der Sensorkörper als ein flexibles Flachbandkabel ausgeformt sein. Ebenso gut ist es vorstellbar, den Sensorkörper als einen Dichtkörper auszugestalten oder den Sensorkörper in einen Dichtkörper zu integrieren. Der Dichtkörper ist dabei vorgesehen, das Stellelement gegenüber der Schließkante im geschlossenen Zustand abzudichten. Als Beispiel hierfür kann eine Dichtlippe erwähnt werden, die eine betätigbare Seitenscheibe eines Kraftfahrzeugs gegenüber ihrer Schließkante abdichtet.

Vorteilhafterweise ist der Einklemmsensor als ein flexibles Flachbandkabel ausgeformt. Ein flexibles Flachbandkabel wird auch als FFC ("Flexible Flat Cable") bezeichnet, und zeichnet sich dadurch aus, dass in einem flexiblen Kabelkörper parallele Leiterstrukturen verlegt sind.

Alternativ zu einem FFC kann als Sensorkörper auch eine flexible Leiterstruktur verwendet werden. Eine flexible Leiterstruktur ist auch unter dem Begriff FPC ("Flexible Printed Circuit") bekannt. Dabei sind in einem flexiblen Isoliermaterial, insbesondere in mehrschichtiger Anordnung, Leiterbahnen spezifisch angeordnet oder verlegt. Eine solche Ausgestaltung erlaubt eine hohe Flexibilität hinsichtlich der Dimensionierung und Anordnung der einzelnen Leiterbahnen, so dass die Messelektroden des Einklemmsensors in gewünschter Art und Weise angeordnet oder dimensioniert werden können.

In einer weiteren vorteilhaften Ausgestaltung erstreckt sich der Sensorkörper in eine Längsrichtung, wobei die Elektroden entlang der Längsrichtung jeweils in einzeln ansteuerbare Einzelelektroden unterteilt sind. Hierdurch wird erreicht, dass sich die jeweils zwischen der Mess- bzw. Kalibrierelektrode und der Gegenelektrode messbare Kapazität verringert, da die gesamte Fläche der Mess- bzw. Kalibrierelektrode in mehrere unterbrochene Einzelflächen der getrennten Elektroden aufgeteilt ist. Eine niedrige, sich insgesamt zwischen den Elektroden im Sensorkörper und Gegenelektrode ausbildende Kapazität führt jedoch dazu, dass sich eine kleine Kapazitätsänderung im Verhältnis zur Gesamtkapazität leichter detektieren lässt. Das Verhältnis aus Kapazitätsänderung und Gesamtkapazität verschiebt sich zu Gunsten der Kapazitätsänderung. Ein derart ausgestalteter Einklemmsensor erlaubt zudem die Detektion einer Kapazitätsänderung mittels eines Multiplex-Verfahrens. Dabei können die einzelnen Elektroden mittels separater Zuleitungen entweder zeitlich versetzt (seriell) oder gleichzeitig (parallel) angesteuert werden. Insgesamt ist mit dieser Anordnung auch eine Ortsauflösung der Schmutz- oder Wasserdetektion in Längsrichtung des Sensors ermöglicht.

Der Sensor kann in einfacher Art und Weise zum Erkennen eines Hindernisses im Weg eines Stellelements eines Kraftfahrzeugs eingesetzt werden, wenn als Gegenelektrode die geerdete Karosserie des Kraftfahrzeugs dient. Hierzu wird der beschriebene Sensor derart entlang von Konturen des Kraftfahrzeugs geführt, dass die Abschirmelektrode zwischen der Karosserie und den Elektroden zum Liegen kommt. Es wird hierbei die sich zwischen den Elektroden und der geerdeten Karosserie gebildete Kapazität detektiert. Der Sensor ist bevorzugt an einem beweglichen Teil des Stellelements angeordnet, beispielweise an einer Heckklappe des Kraftfahrzeugs, er kann aber auch an einem der Heckklappe gegenüberliegenden Bereich der Karosserie angeordnet sein.

Ausführungsbeispiele der Erfindung werden anhand einer Zeichnung näher erläutert. Dabei zeigen:
- Fig. 1: in einem Querschnitt einen Einklemmsensor, der auf einer Gegenelektro- de angeordnet ist,
- Fig. 2: schematisch den Einklemmsensor gemäß Fig. 1 mit einer vereinfachen- den Darstellung der Feldlinien des zur Gegenelektrode erzeugten äußeren elektrischen Feldes,
- Fig. 3: in einem Schaubild die resultierenden Kapazitäten im Falle eines benetz- ten Einklemmsensors gemäß Fig. 1,
- Fig. 4: in einem Querschnitt schematisch einen weiteren Einklemmsensor mit Abschirmelektrode und dem Verlauf der Feldlinien in einer Messphase,
- Fig. 5: in einem Querschnitt schematisch den Einklemmsensor gemäß Fig. 4 mit dem Verlauf der Feldlinien in einer Kalibrierphase, und
- Fig. 6: den zeitlichen Verlauf zweier Wechselspannungssignale.

Gleiche Bezugszeichen haben in den verschiedenen Figuren die gleiche Bedeutung.

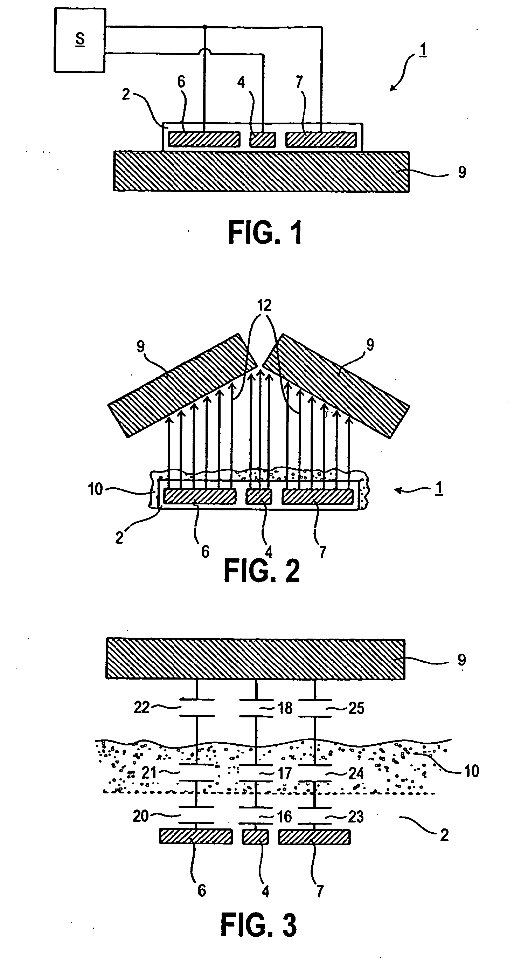

Fig. 1 zeigt schematisch den Querschnitt eines Einklemmsensors 1, welcher insbesondere zum Erkennen eines Hindernisses im Weg eines Stellelements eines Kraftfahrzeugs einsetzbar ist. Der Einklemmsensor 1 umfasst einen langgestreckten Sensorkörper 2 aus einem elektrisch isolierenden Material. In dem Sensorkörper 2 ist etwa mittig eine Kalibrierelektrode 4 zwischen zwei baugleichen Messelektroden 6, 7 angeordnet. Die Elektroden 4,6 und 7 sind jeweils als Flachleiter ausgebildet, die sich senkrecht zur Zeichenebene erstrecken. Der Einklemmsensor 1 ist einer Gegenelektrode 9 aufgelegt, die beispielsweise durch die geerdete Karosserie eines Kraftfahrzeugs gebildet ist.

Zur Verwendung des Einklemmsensors 1 werden die Elektroden 4,6 und 7 mittels der Steuereinheit S beispielsweise gegenüber der Gegenelektrode 9 mit einer Wechselspannung gegenüber Masse beaufschlagt. Dabei sind die Elektroden 4, 6 und 7 in einer Messphase, in der ein Hindernis im Weg des Stellelements detektiert werden soll, zueinander elektrisch parallel geschaltet und befinden sich somit stets auf dem gleichen elektrischen Potential. Aufgrund der Potenzialdifferenz zwischen den Elektroden 4,6 und 7 und der Gegenelektrode 9 bildet sich im Isolierkörper 2 ein direktes elektrisches Feld sowie im der Gegenelektrode 9 abgewandten Raum ein schwächeres äußeres elektrisches Streufeld. Die Elektroden 4,6 und 7 bilden jeweils mit der Gegenelektrode 9 einen Kondensator mit einer durch die Dimensionierung des Einklemmsensors 1 bedingten charakteristischen Messkapazität aus. Dabei können die Elektroden 4, 6 und 7 durch ihre Parallelschaltung wie eine einzige Elektrode betrachtet werden.

Die Feldlinien des Streufeldes des aus Gegenelektrode 9 und Elektroden 4, 6, 7 gebildeten Kondensators verlaufen bogenförmig nach beiden Seiten über die der Gegenelektrode 9 abgewandten Seite des Sensorkörpers 2 zu der Gegenelektrode 9. Somit wird ein sich dem Einklemmsensor 1 aus dem Fernbereich näherndes Dielektrikum von den Feldlinien durchdrungen, was zu einer detektierbaren Änderung der Kapazität zwischen den Elektroden 4,6,7 und der Gegenelektrode führt.

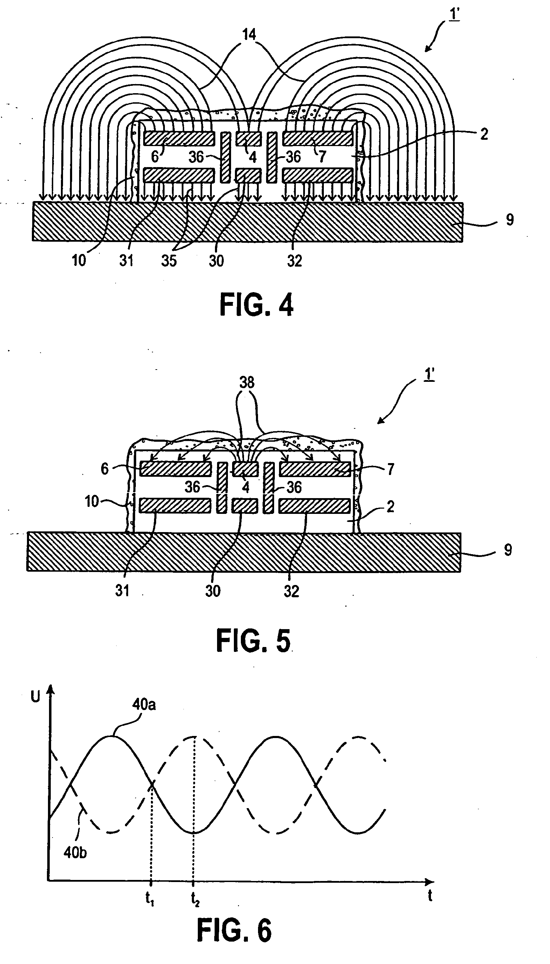

Die Steuereinheit S ist weiter dafür eingerichtet, die Kalibrierelektrode 4 in einer Kalibrierphase auf ein Potential zu legen, welches von dem Potential der Messelektroden 6 und 7 verschieden ist. Der dann geänderte Feldlinienverlauf in der Kalibrierphase kann sinngemäß aus Fig. 5 entnommen werden.

In Fig. 2 ist in einer vereinfachenden Darstellung der Feldverlauf des Einklemmsensors 1 gemäß Fig. 1 dargestellt. Dabei ist zum besseren Verständnis die Gegenelektrode 9 gedanklich mittig unterhalb des Einklemmsensors 1 gemäß Fig. 1 geteilt und die entstehenden Hälften nach oben geklappt.

Aus dieser vereinfachenden Darstellung resultiert ein geradliniger Feldlinienverlauf der in der Messphase entstehenden äußeren elektrischen Felder.

Zur Veranschaulichung ist weiter auf der Oberfläche des Sensorkörpers 2 des Einklemmsensors 1 als Verschmutzung ein Wasserfilm 10 dargestellt. Man erkennt den Feldlinienverlauf des Messfeldes 12, welches sich bei einer Potenzialdifferenz zwischen der Gegenelektrode 9 und den Elektroden 4, 6 und 7 ausbildet.

In dieser schematisierenden Darstellung ist die für den gezeigten Einklemmsensor 1 maßgebliche direkte Kapazität zwischen den Messelektroden 4,6 und 7 und der Gegenelektrode 9 gedanklich und zeichnerisch eliminiert. Der dargestellte Feldlinienverlauf entspricht dem des äußeren, eher schwachen Streufelds.

Aus der Darstellung gemäß Fig. 2 wird anschaulich klar, wie sich jeweils die Messkapazitäten des aus den jeweiligen Elektroden 4,6 und 7 und der Gegenelektrode 9 gebildeten Kondensators zusammensetzen. Dies ist in einem Schaubild in Fig. 3 dargestellt.

Man erkennt wiederum die Kalibrierelektrode 4, die Messelektroden 6 und 7 sowie die "aufgeklappte" Gegenelektrode 9. Auf den Elektroden 4,6 und 7 bzw. auf dem Sensor körper 2 befindet sich wiederum ein Wasserfilm 10 in Form einer flächigen Benetzung.

Es wird verständlich, dass sich jede Kapazität der Elektroden 4, 6, 7 mit der Gegenelektrode 9 jeweils aus drei schaltungstechnisch in Serie geschalteten Einzelkapazitäten zusammensetzt. Zwischen jeder Elektrode 4,6 bzw. 7 und der Gegenelektrode 9 ist das Material des Sensorkörpers 2, der Wasserfilm 10 sowie als Übertragungsmedium Luft angeordnet. Insofern kann die Kapazität des die Kalibrierelektrode 4 umfassenden Kondensators betrachtet werden als eine Serienschaltung der Kapazitäten 16,17 und 18. Entsprechend können die durch die äußeren Messelektroden 6 und 7 gebildeten Kapazitäten jeweils als Serienschaltung der Kapazitäten 20,21 sowie 22 bzw. 23,24 und 25 betrachtet werden.

Um das Streufeld der durch die Messelektroden 4, 6 und 7 gebildeten Kondensatoren zu erhöhen, ist bei dem gemäß Fig. 4 in einem Querschnitt dargestellten Einklemmsensor 1' eine Abschirmelektrode zwischen die Messelektroden 4, 6 und 7 und der Gegenelektrode 9 eingebracht. Dabei ist die Abschirmelektrode in eine erste, zweite und dritte Abschirmelektrode 30,31 bzw. 33 unterteilt, die jeweils den entsprechenden Elektroden 4,6 und 7 zugeordnet sind. Über eine entsprechende, hier nicht dargestellte Schaltung wird auf schaltungstechnischem Wege erreicht, dass sich die Abschirmelektroden 30,31 und 33 in der Messphase auf demselben Potenzial befinden wie die Elektroden 4,6 bzw. 7. Mit anderen Worten werden die Abschirmelektroden 30,31 und 33 als so genannte Driven-Shield-Elektroden eingesetzt. Aufgrund der resultierenden Potenzialverhältnisse wird somit durch die Abschirmelektroden 30,31 und 33 verhindert, dass sich zwischen den Messelektroden 4,6 und 7 und der Gegenelektrode 9 eine direkte Kapazität bzw. ein direktes elektrisches Messfeld 14, ausbildet. Somit wird über die Messelektroden 4,6 und 7 jeweils ein Streufeld zur Gegenelektrode 9 erzeugt, welches in einen vom Einklemmsensors 1' zu erfassenden Gefährdungsbereich auf der der Gegenelektrode 9 abgewandten Seite gerichtet ist. Die Empfindlichkeit im Erfassungsbereich des Einklemmsensors 1' ist gegenüber der Empfindlichkeit im Erfassungsbereich des Einklemmsensors 1 deutlich vergrößert. Das Messfeld 14 wird von den Abschirmelektroden 30, 31 und 32 zur Gegenelektrode 9 erzeugt, was durch die entsprechend eingezeichneten Feldlinien des direkten elektrischen Feldes 35 verdeutlicht ist

Auch der Einklemmsensor 1 ' umfasst einen sich in Längsrichtung erstreckenden flachen Sensorkörper 2 aus einem elektrischen lsoliermaterial. Der Sensorkörper 2 ist wiederum einer Gegenelektrode 9 aufgelegt. Die innere Kalibrierelektrode 4 und die Messelektroden 6 und 7 sind jeweils als Flachleiter ausgebildet. Ebenso sind die Abschirmelektroden 30, 31 und 32 als Flachleiter ausgebildet, die den entsprechenden Messelektroden 4, 6 bzw. 7 zugeordnet sind. Alle Flachleiter erstrecken sich senkrecht zur Zeichenebene.

Weiterhin sind zwei Zusatzelektroden 36 vorgesehen, die in der Messphase mit dem gleichen Potential verbunden sind wie die Elektroden 4, 6 und 7 und die Abschirmelektroden 30,31 und 32.

Eine auf der Oberfläche des Sensorkörpers 2 befindliche Schmutzablagerung oder ein die Oberfläche benetzender Wasserfilm bewirkt eine Änderung der Messkapazität des aus den Elektroden 4, 6, 7 und der Gegenelektrode 9 gebildeten Kondensators. Im Gegensatz zu einem Hindernis im Weg des Stellelements liegt die Ablagerung 10 jedoch unmittelbar über dem Sensorkörper 2. Während es sich bei dem Hindernis um eine Fernfeldstörung handelt, beeinflusst die Ablagerung 10 lediglich das Nahfeld. Um die allein durch die Ablagerung 10 verursachte Nahfeldstörung detektieren zu können, wird in einer Kalibrierphase ein zweites elektrisches Feld, ein Kalibrierfeld 38 aufgebaut, dessen Reichweite über dem Sensorkörper 2 kleiner ist als die des Messfeldes 12. Dies wird dadurch erreicht, indem die Kalibrierelektrode 4 und die Messelektroden 6, 7 auf verschiedene Potentiale gelegt werden, so dass sich die Feldlinien des Kalibrierfeldes 38 von der Kalibrierelektrode 4 in Richtung der Messelektroden 6, 7 erstrecken, wie es aus Fig. 5 zu entnehmen ist.

Dank der mittigen Anordnung der Kalibrierelektrode 4 erstrecken sich bei dieser Ausführungsvariante die Feldlinien des Kalibrierfeldes 38 nach beiden Seiten über die der Gegenelektrode 9 abgewandten Seite des Sensorkörpers 2 in Richtung der Messelektroden 6, 7 und erreichen im Wesentlichen nicht die Gegenelektrode 9, so dass sich das Kalibrierfeld 38 über dem Sensorkörper 2 ausbildet.

In der Kalibrierphase sind sowohl die Zusatzelektroden 36 als auch die Abschirmelektrode 30 auf demselben Potential wie die Kalibrierelektrode 4 gelegt und schirmen somit die Kalibrierelektrode 4 gegenüber der Gegenelektrode 9, den Messelektroden 6, 7 und eventuell den Abschirmelektroden 31, 32 ab. Die Zusatzelektroden 36 verhindern insbesondere die Ausbildung eines direkten elektrischen Feldes zwischen der Kalibrierelektrode 4 und den nahepositionierten Messelektroden 6, 7. Die Abschirmelektroden 31, 32 werden z.B. mit dem gleichen Potential verbunden wie die Messelektroden 6 und 7, können aber auch ein anderes Potential aufweisen.

Unterschiedliche Potentiale auf der Kalibrierelektrode 4 und den Messelektroden 6, 7 können erzielt werden, indem man beispielweise die Elektroden 4, 6, 7 mit einer Wechselspannung beaufschlagt, wobei sich die Wechselspannung der Kalibrierelektrode 4 von der der Messelektroden 6, 7 in ihrer Phase bzw. der Frequenz unterscheidet.

Ein Beispiel für den Verlauf zweier Wechselspannungssignale 40a, 40b, mit denen die Kalibrierelektrode 4 und den Messelektroden 6, 7 entsprechend beaufschlagt werden und die sich in ihrer Phase zueinander um π unterscheiden, ist in Fig. 6 veranschaulicht. Zum Zeitpunkt t₁ schneiden sich die Kurven der Verläufe beider Wechselspannungen 40a, 40b. Im Zeitpunkt t₂ ist die Amplitude beider Wechselspannungssignale 40a, 40b am größten, das heißt das Kalibrierfeld zwischen der Kalibrierelektrode 4 und den Messelektroden 6, 7 ist am intensivsten. Aus dem Verlauf der Messkapazität insgesamt kann bei einer derartigen Ansteuerung auf die Kalibrierkapazität rückgeschlossen werden und diese zur Anpassung einer Auslöseschwelle für die Messkapazität herangezogen werden.

Zur Ansteuerung der Wechselspannungen 40a, 40b ist eine hier nicht dargestellte steuerbare Spannungsquelle vorgesehen, die von einer Steuereinheit entsprechend angesteuert wird. Die Steuereinheit kann insbesondere als ein Mikrocontroller ausgebildet sein. Die Steuereinheit spielt in diesem Ausführungsbeispiel auch die Rolle einer Auswerteeinheit, obwohl als Steuereinheit und Auswerteeinheit auch separate Einheiten herangezogen werden können. Die Steuereinheit erfasst aus der Kalibrierphase die Kalibrierkapazität des zwischen der Kalibrierelektrode 4 und den Messelektroden 6, 7 ausgebildeten Kalibrierfeldes und vergleicht ihren Wert mit dem Wert aus der letzen durchgeführten Messung der Kalibrierkapazität. Wenn bei diesem Vergleich Änderungen festgestellt werden, so deuten diese auf das Vorhandensein einer Ablagerung 10 aus Schmutz oder Wasser auf der Oberfläche des Sensorkörpers 2.

Der erfasste Wert der Kalibrierkapazität wird weiterhin gespeichert und bei der Auswertung der Messkapazität in der Messphase berücksichtigt. Bei der Auswertung der erfassten Messkapazität wird daher die Auslöseschwelle, deren Überschreitung durch die aktuell gemessene Messkapazität als ein Vorhandensein eines Hindernisses im Weg des Stellelements interpretiert wird, nachgeführt. Um eine Fehldetektion eines Hindernisses zu vermeiden, wird diese Auslöseschwelle abhängig von der gemessenen Kalibrierkapazität aktualisiert, da eine Änderung der Kalibrierkapazität auch zu einem geänderten Erwartungswert der Messkapazität im Normalbetrieb führt. Der Einfluss der Kalibrierkapazität auf die Messkapazität ist von dem Aufbau und der Dimensionierung des Einklemmschutzes 1' abhängig und kann grundsätzlich für das System bestimmt werden. So ist z.B. eine softwarebedingte Nachführung der Auslöseschwelle möglich, bei der der Verlauf der Messkapazität und somit der Auslöseschwelle an den Verlauf der Kalibrierkapazität angepasst wird. Alternativ wird nur der Verlauf der Auslöseschwelle in Abhängigkeit vom Verlauf der Kalibrierkapazität aktualisiert und bei der Auswertung der Messkapazität herangezogen.

Alternativ zum Verbinden der Elektroden 4, 6, 7 mit Wechselspannungen unterschiedlicher Phase und/oder Frequenz können die Messelektroden 6, 7 während der Messphase mit einem Grundpotential, insbesondere mit dem Erdpotential verbunden werden. Die Einstellung der Mess- und der Kalibrierphase kann hierbei ebenfalls periodisch, insbesondere abwechselnd erfolgen.

### Bezugszeichenliste

- 1,1': Einklemmsensor
- 2: Sensorkörper
- 4: Kalibrierelektrode
- 6,7: Messelektroden
- 9: Gegenelektrode (Karosserie)
- 10: Ablagerung
- 14: elektrisches Feld
- 16: Kapazität Sensorkörper
- 17: Kapazität Ablagerung
- 18: Kapazität Luft
- 20: Kapazität Sensorkörper
- 21: Kapazität Ablagerung
- 22: Kapazität Luft
- 23: Kapazität Sensorkörper
- 24: Kapazität Ablagerung
- 25: Kapazität Luft
- 30, 31, 32: Abschirmelektroden
- 35: elektrisches Feld
- 36: Zusatzelektrode
- 38: Kalibrierfeld
- 40a, 40b: Wechselspannungssignal
- S: Steuereinheit

## Patentansprüche

1. Einklemmsensor (1, 1 '), insbesondere zum Erkennen eines Hindernisses im Weg eines Stellelements eines Kraftfahrzeugs, mit einem Sensorkörper (2), mit einer im Sensorkörper (2) angeordneten, auf ein Messpotential legbaren Messelektrode (6, 7), mit einer der Messelektrode (6, 7) im Sensorkörper (2) benachbart angeordneten elektrisch getrennten, auf ein Kalibrierpotential legbaren Kalibrierelektrode (4), und mit einer Steuereinheit (S) **dadurch gekennzeichnet, dass** diese dafür eingerichtet ist, die Messelektrode (6, 7) und die Kalibrierelektrode (4) derart anzusteuern, dass sich das Messpotential und das Kalibrierpotential in einer Messphase gleichen und in einer Kalibrierphase voneinander unterscheiden.

2. Einklemmsensor (1,1') nach Anspruch 1, wobei die Steuereinheit (S) dafür eingerichtet ist, während der Kalibrierphase eine Kalibrierkapazität zu erfassen und zu speichern und diese Kalibrierkapazität bei der Auswertung einer in der Messphase erfassten Messkapazität zu berücksichtigen.

3. Einklemmsensor (1, 1') nach einem der vorhergehenden Ansprüche, wobei die Steuereinheit (S) dafür eingerichtet ist, die Messelektrode (6, 7) und die Kalibrierelektrode (4) jeweils mit einer Wechselspannung (40b, 40a) anzusteuern, wobei sich die Wechselspannungen (40b, 40a) in ihren Phasen zueinander oder in ihren Frequenzen unterscheiden.

4. Einklemmsensor (1,1') nach Anspruch 1 oder 2, wobei die Steuereinheit (S) dafür eingerichtet ist, in der Kalibrierphase die Messelektrode (6, 7) mit einem Grundpotential zu verbinden.

5. Einklemmsensor (1, 1') nach einem der vorhergehenden Ansprüche, wobei die Steuereinheit (S) als ein Mikrokontroller ausgebildet ist.

6. Einklemmsensor (1,1') nach einem der vorhergehenden Ansprüche, wobei die Messelektrode (6, 7) und die Kalibrierelektrode (4) jeweils kammförmig ausgebildet sind, wobei die Kammstrukturen von Messelektrode (6, 7) und Kalibrierelektrode (4) ineinandergreifen.

7. Einklemmsensor (1,1') nach einem der Ansprüche 1 bis 5, wobei die Elektroden (4, 6, 7) flächig ausgebildet sind und die Fläche der Messelektrode (6, 7) größer ist als die Fläche der Kalibrierelektrode (4).

8. Einklemmsensor (1, 1') nach einem der vorhergehenden Ansprüche, wobei zwei Messelektroden (6, 7), insbesondere zwei baugleiche Messelektroden (6, 7) vorgesehen sind, die in den Randbereichen des Sensorkörpers (2) angeordnet sind.

9. Einklemmsensor (1, 1`) nach einem der vorhergehenden Ansprüche, der mindestens eine separate Abschirmelektrode (30, 31, 32) umfasst, die zur Ausrichtung eines Messfeldes (14) in der Messphase in einen Gefährdungsbereich ausgebildet ist.

10. Einklemmsensor (1,1') nach Anspruch 9, wobei die Abschirmelektrode (30, 31, 32) zur Ausrichtung eines Kalibrierfeldes (38) in der Kalibrierphase in einen Nahbereich ausgebildet ist.

11. Einklemmsensor (1, 1') nach Anspruch 9 oder 10, wobei die Abschirmelektrode (30, 31, 32) in einzelne, jeweils den Elektroden (4, 6, 7) gegenüber angeordnete und getrennte Einzelabschirmelektroden unterteilt ist.

12. Einklemmsensor (1, 1') nach einem der vorhergehenden Ansprüche, der eine Zusatzelektrode (36) zwischen der Kalibrierelektrode (4) und der Messelektrode (6, 7) umfasst, die auf das gleiche Potential wie die Kalibrierelektrode (4) legbar ist.

13. Einklemmsensor (1, 1`) nach einem der vorhergehenden Ansprüche, wobei der Sensorkörper (2) aus einem flexiblen Trägermaterial gebildet ist.

14. Einklemmsensor (1, 1') nach einem der vorhergehenden Ansprüche, der als ein flexibles Flachbandkabel ausgeformt ist.

15. Einklemmsensor (1,1') nach Anspruch 13, wobei der Sensorkörper (2) eine flexible Leiterstruktur umfasst .

16. Einklemmsensor (1, 1') nach einem der vorhergehenden Ansprüche, wobei sich der Sensorkörper (2) in einer Längsrichtung erstreckt, und wobei die Elektroden (4, 6, 7) entlang der Längsrichtung jeweils in einzeln ansteuerbare Einzelelektroden unterteilt sind.

17. Einklemmsensor (1, 1') nach einem der vorhergehenden Ansprüche, der eine gegenüber der Messelektrode (6, 7) und der Kalibrierelektrode (4) angeordnete Gegenelektrode (9) umfasst, die insbesondere durch die Karosserie des Kraftfahrzeugs gebildet ist.

## Claims

1. Anti-pinch sensor (1, 1'), in particular for identifying an obstacle in the path of an actuating element of a motor vehicle, having a sensor body (2), having a measurement electrode (6, 7) which is arranged in the sensor body (2) and can be connected to a measurement potential, having a calibration electrode (4) which is arranged adjacent to the measurement electrode (6, 7) in the sensor body (2), is electrically disconnected and can be connected to a calibration potential, and having a control unit (S), **characterized in that** the said control unit is designed to control the measurement electrode (6, 7) and the calibration electrode (4) in such a way that the measurement potential and the calibration potential are equal in a measurement phase and differ from one another in a calibration phase.

2. Anti-pinch sensor (1, 1') according to Claim 1, with the control unit (S) being designed to record and to store a calibration capacitance during the calibration phase, and to take this calibration capacitance into account when evaluating a measurement capacitance which is recorded in the measurement phase.

3. Anti-pinch sensor (1, 1') according to either of the preceding claims, with the control unit (S) being designed to control the measurement electrode (6, 7) and the calibration electrode (4) with an AC voltage (40a, 40b) in each case, with the AC voltages (40a, 40b) differing in terms of their phases in relation to one another or in terms of their frequencies.

4. Anti-pinch sensor (1, 1') according to Claim 1 or 2, with the control unit (S) being designed to connect the measurement electrode (6, 7) to an earth potential in the calibration phase.

5. Anti-pinch sensor (1, 1') according to one of the preceding claims, with the control unit (S) being in the form of a microcontroller.

6. Anti-pinch sensor (1, 1') according to one of the preceding claims, with the measurement electrode (6, 7) and the calibration electrode (4) each being in the form of a comb, with the comb structures of the measurement electrode (6, 7) and of the calibration electrode (4) engaging one in the other.

7. Anti-pinch sensor (1, 1') according to one of Claims 1 to 5, wherein the electrodes (4, 6, 7) are flat, and the surface area of the measurement electrode (6, 7) is greater than the surface area of the calibration electrode (4).

8. Anti-pinch sensor (1, 1') according to one of the preceding claims, with two measurement electrodes (6, 7), in particular two physically identical measurement electrodes (6, 7), being provided, the said electrodes being arranged in the edge regions of the sensor body (2).

9. Anti-pinch sensor (1, 1') according to one of the preceding claims, which comprises at least one separate shielding electrode (30, 31, 32) which is designed to direct a measurement field (14) into a hazard region in the measurement phase.

10. Anti-pinch sensor (1, 1') according to Claim 9, with the shielding electrode (30, 31, 32) being designed to direct a calibration field (38) into a near region in the calibration phase.

11. Anti-pinch sensor (1, 1') according to Claim 9 or 10, with the shielding electrode (30, 31, 32) being divided into several separate individual shielding electrodes which are each arranged opposite the electrodes (4, 6, 7).

12. Anti-pinch sensor (1, 1') according to one of the preceding claims, which comprises an auxiliary electrode (36) between the calibration electrode (4) and the measurement electrode (6, 7), it being possible for the said auxiliary electrode to be connected to the same potential as the calibration electrode (4).

13. Anti-pinch sensor (1, 1') according to one of the preceding claims, with the sensor body (2) being formed from a flexible carrier material.

14. Anti-pinch sensor (1, 1') according to one of the preceding claims, which is formed as a flexible ribbon cable.

15. Anti-pinch sensor (1, 1') according to Claim 13, with the sensor body (2) comprising a flexible conductor structure.

16. Anti-pinch sensor (1, 1') according to one of the preceding claims, with the sensor body (2) extending in a longitudinal direction, and with the electrodes (4, 6, 7) in each case being divided into several controllable individual electrodes in the longitudinal direction.

17. Anti-pinch sensor (1, 1') according to one of the preceding claims, which comprises a mating electrode (9) which is arranged opposite the measurement electrode (6, 7) and the calibration electrode (4) and is formed, in particular, by the body of the motor vehicle.

## Revendications

1. Détecteur anti-pincement (1, 1'), notamment destiné à la détection d'un obstacle dans le parcours de déplacement d'un élément réglable d'un véhicule automobile, comprenant
un corps de détecteur (2),
une électrode de mesure (6, 7) agencée dans le corps de détecteur (2) et à laquelle peut être appliqué un potentiel de mesure,
une électrode de calibrage (4) agencée au voisinage de l'électrode de mesure (6, 7) dans le corps de détecteur (2), électriquement isolée, et à laquelle peut être appliqué un potentiel de calibrage, et
une unité de commande (S),
**caractérisé en ce que** celle-ci est conçue pour pouvoir commander ou alimenter l'électrode de mesure (6, 7) et l'électrode de calibrage (4) de manière à ce que le potentiel de mesure et le potentiel de calibrage soient semblables dans une phase de mesure et soient différents l'un de l'autre dans une phase de calibrage.

2. Détecteur anti-pincement (1, 1') selon la revendication 1, dans lequel l'unité de commande (S) est conçue pour relever, pendant la phase de calibrage, une capacité de calibrage, et mémoriser celle-ci, et pour prendre en considération cette capacité de calibrage lors du traitement d'exploitation d'une capacité de mesure relevée au cours de la phase de mesure.

3. Détecteur anti-pincement (1, 1') selon l'une des revendications précédentes, dans lequel l'unité de commande (S) est conçue pour alimenter l'électrode de mesure (6, 7) et l'électrode de calibrage (4) chacune avec une tension alternative (40b, 40a), les tensions alternatives (40b, 40a) se différenciant l'une de l'autre quant à leurs phases ou à leurs fréquences.

4. Détecteur anti-pincement (1, 1') selon la revendication 1 ou la revendication 2, dans lequel l'unité de commande (S) est conçue pour relier l'électrode de mesure (6, 7) à un potentiel de base dans la phase de calibrage.

5. Détecteur anti-pincement (1, 1') selon l'une des revendications précédentes, dans lequel l'unité de commande (S) est réalisée sous la forme d'un microcontrôleur.

6. Détecteur anti-pincement (1, 1') selon l'une des revendications précédentes, dans lequel l'électrode de mesure (6, 7) et l'électrode de calibrage (4) sont réalisées chacune en forme de peigne, les structures de peigne de l'électrode de mesure (6, 7) et de l'électrode de calibrage (4) engrenant mutuellement.

7. Détecteur anti-pincement (1, 1') selon l'une des revendications 1 à 5, dans lequel les électrodes (4, 6, 7) sont d'une configuration en forme de nappe mince, et la surface de l'électrode de mesure (6, 7) est plus grande que la surface de l'électrode de calibrage (4).

8. Détecteur anti-pincement (1, 1') selon l'une des revendications précédentes, dans lequel sont prévues deux électrodes de mesure (6, 7), notamment deux électrodes de mesure (6, 7) de même construction, qui sont agencées dans les zones de bordure du corps de détecteur (2).

9. Détecteur anti-pincement (1, 1') selon l'une des revendications précédentes, qui comprend au moins une électrode de blindage (30, 31, 32) séparée, qui est configurée pour orienter un champ de mesure (14), lors de la phase de mesure, dans une zone de danger potentiel.

10. Détecteur anti-pincement (1, 1') selon la revendication 9, dans lequel l'électrode de blindage (30, 31, 32) est configurée pour orienter un champ de calibrage (38), lors de la phase de calibrage, dans une zone de proximité.

11. Détecteur anti-pincement (1, 1') selon la revendication 9 ou la revendication 10, dans lequel l'électrode de blindage (30, 31, 32) est subdivisée en électrodes de blindage individuelles séparées, respectivement agencées à l'opposé des électrodes (4, 6, 7).

12. Détecteur anti-pincement (1, 1') selon l'une des revendications précédentes, qui comprend, entre l'électrode de calibrage (4) et l'électrode de mesure (6, 7), une électrode auxiliaire (36) à laquelle peut être appliqué le même potentiel qu'à l'électrode de calibrage (4).

13. Détecteur anti-pincement (1, 1') selon l'une des revendications précédentes, dans lequel le corps de détecteur (2) est formé par un matériau de support flexible.

14. Détecteur anti-pincement (1, 1') selon l'une des revendications précédentes, qui est réalisé sous la forme d'un câble plat en bande, flexible.

15. Détecteur anti-pincement (1, 1') selon la revendication 13, dans lequel le corps de détecteur (2) comprend une structure conductrice flexible.

16. Détecteur anti-pincement (1, 1') selon l'une des revendications précédentes, dans lequel le corps de détecteur (2) s'étend dans une direction longitudinale, et dans lequel les électrodes (4, 6, 7) sont respectivement subdivisées, dans la direction longitudinale, en électrodes individuelles pouvant être commandées ou alimentées individuellement.

17. Détecteur anti-pincement (1, 1') selon l'une des revendications précédentes, qui comprend une électrode conjuguée (9) agencée en regard de l'électrode de mesure (6, 7) et de l'électrode de calibrage (4), et en particulier formée par la carrosserie du véhicule automobile.
